# EUROPÄISCHE PATENTSCHRIFT

(11) **EP 3 093 123 B1**
(45) Veröffentlichungstag und Bekanntmachung des Hinweises auf die Patenterteilung: **19.06.2019**
(21) Anmeldenummer: 16163538.8
(22) Anmeldetag: 01.04.2016
(51) Int. Cl.: B33Y 80/00, B29C 64/277, B29C 64/135

(54) **VERFAHREN ZUM HERSTELLEN EINER DREIDIMENSIONALEN STRUKTUR**
METHOD FOR PRODUCING A THREE-DIMENSIONAL STRUCTURE
PROCÉDÉ DE FABRICATION D'UNE STRUCTURE TRIDIMENSIONNELLE

(30) Priorität: 13.05.2015 DE 102015208852
(43) Veröffentlichungstag der Anmeldung: 16.11.2016
(73) Patentinhaber: Nanoscribe GmbH, 76344 Eggenstein-Leopoldshafen (DE)
(72) Erfinder: REINER, Roman Reinhard, 76131 Karlsruhe (DE); TANGUY, Yann, 76351 Linkenheim-Hochstetten (DE); HOFFMANN, Jörg, 67363 Lustadt (DE)
(74) Vertreter: DREISS Patentanwälte PartG mbB

(56) Entgegenhaltungen:
- EP-A1- 2 565 018
- US-A- 5 198 159

## Beschreibung

Die Erfindung betrifft ein Verfahren zum Herstellen einer dreidimensionalen Struktur gemäß dem Oberbegriff des Anspruchs 1.

Solche Strukturierungsverfahren finden insbesondere zur Erzeugung von Mikro- oder Nanostrukturen, von Prototypen (z.B. sog. "rapid prototyping") oder bei der Erzeugung von Werkstücken mit speziellen Formanforderungen Verwendung, z.B. zu experimentellen Zwecken sowie in Bereichen, in denen große Gestaltungsfreiheit erwünscht ist.

Hierbei werden oftmals Strukturierungseinrichtung genutzt, welche eine vorgegebene Hauptrichtung des Struktureintrags aufweisen. Die Hauptrichtung ist in der konstruktionsbedingt vorgegeben, z.B. durch die Vorzugsrichtung eines strukturierenden Elektronenstrahls, durch die optische Achse einer Laseroptik, durch die Richtung eines Materialaufbaustrahls eines 3D-Druckers oder durch die mechanische Achse eines in drei Raumrichtungen steuerbaren Bearbeitungswerkzeuges.

Die Strukturierungseinrichtung weist in der Regel auch einen konstruktionsbedingt begrenzten Schreibbereich auf. Nur in diesem begrenzten Raumbereich kann eine Strukturierung bzw. ein Struktureintrag erfolgen. Der vorgegebene Schreibbereich ist dabei oftmals kleiner als die insgesamt herzustellende Gesamtstruktur. Daher wird in sog. "Stitching-Verfahren" die gesamte Struktur in eine Vielzahl von Teilstrukturen zerlegt, welche zu dem Schreibbereich der Strukturierungseinrichtung passen und nacheinander geschrieben werden.

Aus der US 4,575,330 A1, US 5,198,159 A oder US 5,247,180 A sind Stereolithografie-Verfahren bekannt, wobei eine gewünschte Struktur aus blockartigen Teilstrukturen oder schichtweise in einem Bad aus flüssigem Lithografiematerial (z.B. einem Photopolymer) durch gezielte Belichtung mit einem Schreibstrahl aufgebaut wird. Hierzu polymerisiert der Schreibstrahl durch lokale Belichtung jeweils Strukturblöcke in einer Schicht an der Oberfläche des Bades aus Lithografiematerial mit einem gewünschten Muster. Durch schrittweises Absenken eines Trägersubstrates in dem Bad aus Lithografiematerial wird dann die Struktur lagenweise aufgebaut. Ein Schichtaufbauverfahren mit den Merkmalen des Oberbegriffs des Anspruchs 1 ist in der EP 2 565 018 A1 beschrieben.

Hierbei besteht das Problem, dass bereits definierte Teilstrukturen das Einbringen einer darauffolgend zu schreibenden Teilstruktur stören können. Beispielsweise können bei blockartiger Zerlegung der Struktur einzelne Abschnitte der bereits definierten Strukturblöcke den Schreibstrahl bei der Definition einer folgenden Teilstruktur verschatten oder behindern. Dies kann zu Strukturierungsfehlern führen. Oftmals ist es daher erforderlich, die gewünschte Struktur in eine sehr große Anzahl von Teilstrukturen zu zerlegen, was zu langen Prozesszeiten für die Zerlegung in die Teilstrukturen und für das Schreiben der Teilstrukturen führen kann.

Der Erfindung liegt die Aufgabe zugrunde, bei möglichst kurzen Prozesszeiten die Zuverlässigkeit und Qualität der Strukturierung zu erhöhen.

Diese Aufgabe wird durch ein Verfahren zur 3D-Strukturierung gemäß Anspruch 1 gelöst. Die Strukturierung erfolgt mittels einer Strukturierungseinrichtung, welche dazu ausgebildet ist, in einem in der Regel konstruktiv vorgegebenen Schreibbereich um eine vorgegebene Hauptrichtung des Struktureintrags konzentriert eine Strukturierung vorzunehmen. Die Gesamtstruktur wird dadurch definiert, dass sequenziell eine Mehrzahl von sich insgesamt zu der Gesamtstruktur ergänzenden Teilstrukturen definiert werden, wobei die sequenziell geschriebenen Teilstrukturen jeweils von einhüllenden Grenzflächen begrenzt sind bzw. durch die einhüllenden Grenzflächen aus der Gesamtstruktur ausgeschnitten sind. Dabei sind die Teilstrukturen derart gewählt, dass die einhüllenden Grenzflächen geneigt zu der Hauptrichtung des Struktureintrags verlaufen, d.h. nicht parallel zu der Hauptrichtung sind bzw. einen nicht verschwindenden Winkel mit der Hauptrichtung einschließen.

Die sich zu der Gesamtstruktur ergänzenden Teilstrukturen können beispielsweise flächig nebeneinander liegen und/oder auch schichtartig übereinander liegen.

Die Hauptrichtung des Struktureintrags ist diejenige Richtung oder Achse, entlang welcher die Strukturierungseinrichtung im Wesentlichen zur Definition der Strukturierung im Schreibbereich wirkt. Die Strukturierung kann z.B. in einem geeigneten Basismaterial (z.B. Lithografielack) erfolgen. So weist beispielsweise eine Lithografieeinrichtung einen Schreibstrahl auf, welcher um eine optische Achse herum wirkt, sodass die optische Achse die Hauptrichtung der als Lithografieeinrichtung ausgebildeten Strukturierungseinrichtung bildet. Der Schreibstrahl kann beispielsweise ein Laserstrahl sein.

Die Herstellung der Gesamtstruktur erfolgt mittels einer Energieeinstrahlmethode in einem durch Energieeintrag vernetzbaren oder polymerisierbaren Lithografiematerial. Die gewünschte dreidimensionale Struktur wird dabei in dem Lithografiematerial durch kontrolliertes und lokales Polymerisieren mittels des Energiestrahls definiert und durch einen sich gegebenenfalls anschließenden Entwicklungsschritt verfestigt und/oder freigelegt. Insbesondere ist das Lithografiematerial durch den Energieeintrag verfestigbar. Selbstverständlich können jedoch auch von Anfang an feste Lithografiematerialen verwendet werden, welche durch den Energieeintrag polymerisiert werden und die Strukturierung in einem folgenden Entwicklungsschritt freigelegt wird. Das Lithografiematerial liegt in seinem unpolymerisierten Zustand vorzugsweise flüssig, viskos, gelförmig oder fest vor. Beispielsweise kommt ein Lithografielack, insbesondere ein Negativlack, zum Einsatz. Vorzugsweise handelt es sich um ein photopolymerisierbares Material, beispielsweise um einen lichtaushärtenden Kunststoff, welcher mit der Energieeinstrahlmethode, zum Beispiel mittels eines Schreibstrahls aus Licht, Laserlicht, UV oder ähnlichem polymerisierbar ist.

Die Polymerisation des Lithografiematerials erfolgt in einem innerhalb des Schreibbereichs räumlich verlagerbaren Fokusbereichs eines Schreibstrahls einer Strahlungsquelle der Strukturierungseinrichtung. Insofern kann es sich bei der Strukturierungseinrichtung vorzugsweise um einen Laserlithografen, Elektronenstrahllithografen oder ähnliches handeln. Zur weiteren Ausgestaltung können in dem Schreibbereich mehrere Schreibstrahle wirken, deren Fokusbereiche gemeinsam die Strukturierung vornehmen.

Die Teilstrukturen sind insbesondere dadurch bestimmt, dass die Gesamtstruktur in die Teilstrukturen zerlegt wird und je eine Teilstruktur unmittelbar von der Grenzfläche eingehüllt wird. Die einhüllenden Grenzflächen sind insofern insbesondere gedachte Hilfsflächen zur Definition der Teilstrukturen. Die Teilstruktur ist beispielsweise als ein durch die Grenzflächen berandeter Ausschnitt aus der Gesamtstruktur definiert.

Die einhüllenden Grenzflächen der Teilstruktur verlaufen derart schräg zur Hauptrichtung des Struktureintrags, dass eine Verdeckung des Struktureintrags entlang der Hauptrichtung durch bereits vorhandene Teilstrukturen vermieden wird. Es ist daher möglich, für die Teilstruktur eine vergleichsweise betragsmäßig große Tiefe entlang der Hauptrichtung zu wählen. Daher ist zur Herstellung der Gesamtstruktur eine Zerlegung in eine nur vergleichsweise geringe Anzahl von Teilstrukturblöcken nötig. Dies ermöglicht deutlich kürzere Rechenzeiten zur Zerlegung der Gesamtstruktur in Teilstrukturen und kürzere Prozesszeiten zum Schreiben der Teilstrukturen, ohne dass die Strukturqualität und Zuverlässigkeit der Strukturherstellung beeinträchtigt wird. Auch kann die Lebensdauer der Strukturierungseinrichtung erhöht werden, da die erforderliche Anzahl an Strukturierungsoperationen insgesamt verringert werden kann.

Für eine jeweilige Teilstruktur verläuft eine Grenzfläche, welche diese Teilstruktur in Richtung entgegengesetzt zu bereits vorhandenen Teilstrukturen abgrenzt derart, dass die nicht an bereits vorhandene Teilstrukturen angrenzende Außenseite der Teilstruktur ausgehend von der Strukturierungseinrichtung verschattungsfrei sichtbar ist. Hierzu ist insbesondere denkbar, dass die Teilstrukturen entlang einer Zerlegungsreihe nacheinander sequenziell geschrieben werden, wobei die eine ausgewählte Teilstruktur in Richtung entgegengesetzt zu den bereits vorhandenen Teilstrukturen abgrenzende Grenzfläche derart verläuft, dass die von dieser Grenzfläche gebildete Außenseite der Teilstruktur zu der Strukturierungseinrichtung zugewandt ist. Insbesondere ist vorteilhaft, wenn die Flächennormale der eine Teilstruktur entgegengesetzt zu bereits vorhandenen Teilstrukturen begrenzenden Grenzfläche (also der Außenseite) außerhalb der Teilstruktur ausgehend von der betrachteten Außenseite nur zu der Strukturierungseinrichtung hin verläuft und nicht von dieser weg.

Die Polymerisation des Lithografiematerials durch den Mechanismus der Zwei-Photonen-Absorption oder der Multi-Photonen-Absorption in dem Fokusbereich des Schreibstrahles erfolgt. Dabei ist das Lithografiematerial vorzugsweise derart ausgebildet und die Strahlungsquelle des Schreibstrahls vorzugsweise derart auf das Lithografiematerial abgestimmt, dass eine Polymerisation nur mittels der Zwei-Photonen-Absorption oder der Multi-Photonen-Absorption möglich ist. Hierzu kann beispielsweise die Wellenlänge des Schreibstrahls so groß gewählt (und damit die zugeordnete Quantenenergie so niedrig sein), dass der für die Polymerisation erforderliche Energieeintrag nur durch gleichzeitige Absorption zweier oder mehrere Quanten erreicht wird. Die Wahrscheinlichkeit für einen solchen Absorptionsprozess ist intensitätsabhängig und im Vergleich zum übrigen Schreibstrahl in dem Fokusbereich deutlich erhöht. Im Rahmen von grundsätzlichen Überlegungen ergibt sich, dass die Wahrscheinlichkeit zur Absorption von zwei oder mehreren Quanten vom Quadrat oder von einer höheren Potenz der Strahlungsintensität abhängen kann. Im Gegensatz hierzu weist die Wahrscheinlichkeit für die Absorption eines Quantums eine andere Intensitätsabhängigkeit auf, insbesondere mit einer geringeren Potenz der Strahlungsintensität. Beim Eindringen des Schreibstrahls in das Lithografiematerial erfolgt außerdem grundsätzlich eine Dämpfung. So kann beispielsweise das Beer'sche Gesetz für die Intensitätsabnahme in Abhängigkeit der Eindringtiefe in das Lithografie gelten.

Dies führt dazu, dass eine ortsauflösende Polymerisation in einem Fokusbereich tief unter der Oberfläche des Lithografiematerials unter Ausnutzung einer Ein-Photonen-Absorption problematisch wäre, da aufgrund der Dämpfung selbst bei einer Fokussierung unterhalb der Oberfläche in dem dann vorliegenden Fokusbereich nicht zwingend die höchste Intensität vorliegt. Der genannte Mechanismus der Zwei-/Multi-Photonen-Absorption ermöglicht eine kontrollierte Strukturdefinition auch unterhalb der Oberfläche des Lithografiematerials.

Vorzugsweise sind die Teilstrukturen dadurch definiert, dass die Gesamtstruktur durch Schnitte mit den einhüllenden Grenzflächen zerlegt wird. Die einhüllenden Grenzflächen sind vorzugsweise eben ausgebildet oder aus ebenen Abschnitten zusammengesetzt, was eine rechentechnisch einfache Zerlegung ermöglicht. Denkbar ist jedoch auch, dass die einhüllenden Grenzflächen gewölbte Abschnitte aufweisen oder gewölbt verlaufen.

Grundsätzlich erfolgt die Zerlegung der Gesamtstruktur in Teilstrukturen vorzugsweise softwaretechnisch. Insofern wird ein die Gesamtstruktur repräsentierender Datensatz (z.B. CAD-Daten) bereitgestellt und gegebenenfalls auf einem Datenträger oder einer Speichereinrichtung der Strukturierungseinrichtung hinterlegt. Hieraus werden insbesondere weitere Datensätze rechnergestützt ermittelt, welche die Teilstrukturen repräsentieren, wobei die Strukturierungseinrichtung gemäß den Datensätzen angesteuert wird. Vorzugsweise werden die Datensätze der Teilstrukturen rechnergestützt durch Schnitte der Gesamtstruktur mit den einhüllenden Grenzflächen ermittelt. Insbesondere erfolgt softwaretechnisch eine vollständige, überlappungsfreie Zerlegung der Gesamtstruktur in die Teilstrukturen.

Vorzugsweise erfolgt die Zerlegung derart, dass sich benachbarte Teilstrukturen entlang wenigstens einer einhüllenden Grenzfläche berühren. Insofern erfolgt vorzugsweise eine vollständige Zerlegung in Teilstrukturen. Dabei können benachbarte Teilstrukturen jeweils wenigstens eine identische einhüllende Grenzfläche aufweisen. Nach Vollendung der Gesamtstruktur sind daher die abgrenzenden Grenzflächen nicht mehr als definierte Strukturen vorhanden, sondern vollständig in die Gesamtstruktur integriert.

Vorzugsweise werden die Teilstrukturen derart ermittelt, dass die einhüllenden Grenzflächen, und insbesondere sämtliche mögliche Tangentialebenen über den gesamten Verlauf der einhüllenden Grenzflächen, mit der Hauptrichtung des Struktureintrags einen spitzen Winkel einschließen, welcher entgegen der Haupteinrichtung des Struktureintrags offen ist oder welcher zu der Strukturierungseinrichtung hin offen ist. Die einhüllenden Grenzflächen sind insbesondere derart ausgerichtet, dass die durch eine Grenzfläche definierte Außenseite einer Teilstruktur der Strukturierungseinrichtung unter einem spitzen Winkel zugewandt ist.

Als vorteilhaft haben sich insbesondere Winkel größer als 0° und kleiner als 45°, vorzugsweise zwischen 5° und 20°, beispielsweise im Bereich von 15° herausgestellt.

Vorzugsweise sind die Teilstrukturen in einem Zerlegungsraster angeordnet und werden sequenziell nacheinander geschrieben, wobei jeweils wenigstens eine einhüllende Grenzfläche einer Teilstruktur parallel zu wenigstens einer oder mehrerer einhüllenden Grenzfläche anderer Teilstrukturen im Zerlegungsraster verläuft. Insbesondere ist denkbar, dass die einhüllenden Grenzflächen der sich zur der Gesamtstruktur ergänzenden Teilstrukturen jeweils paarweise parallel zueinander verlaufen.
Um die Teilstrukturen sequenziell zu schreiben, wird vorzugsweise der Schreibbereich der Strukturierungseinrichtung sequenziell verlagert und positioniert, wobei jeweils nach Verlagerung und Positionierung in dem Schreibfeld eine Teilstruktur geschrieben wird. Zum Verlagern des Schreibbereiches kann entweder die Strukturierungseinrichtung oder ein Substrat relativ zu der Strukturierungseinrichtung verlagert werden.

Die Erfindung wird im Folgenden anhand der Figuren näher erläutert.

Es zeigen:
Figur 1: skizzierte Darstellung zur Erläuterung eines 3D-Strukturierungsverfahren und den dabei auftretenden Problemen mit einer projizierenden Strukturierungseinrichtung;
Figur 2: entsprechende Darstellung zur Figur 1 mit einer strahllenkenden Strukturierungseinrichtung;
Figur 3: skizzierte Darstellung zur Erläuterung des erfindungsgemäßen Verfahrens mit einer projizierenden Strukturierungseinrichtung;
Figur 4: skizzierte Darstellung zur Erläuterung des erfindungsgemäßen Verfahrens mit einer scannenden Strukturierungseinrichtung.

In der nachfolgenden Beschreibung sowie in den Figuren sind für identische oder einander entsprechende Merkmale jeweils dieselben Bezugszeichen verwendet.

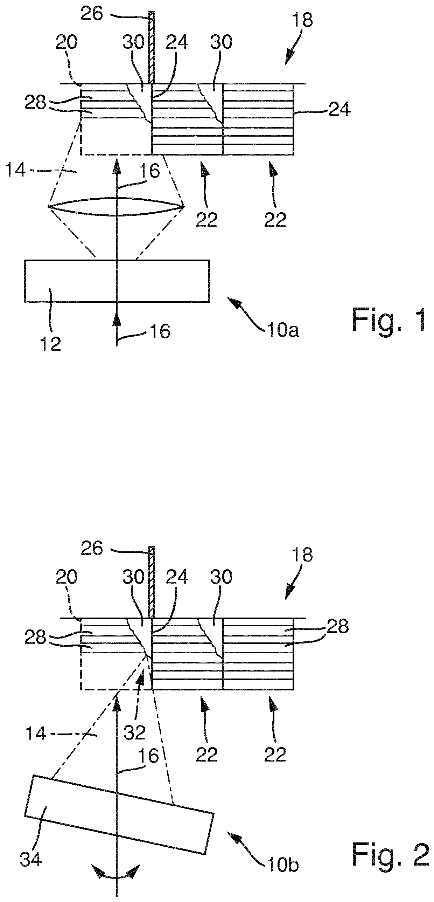

In der skizzierten Darstellung der Figuren 1 bis 4 ist jeweils eine Strukturierung durch Polymerisation eines (nicht im Detail dargestellten) Lithografiematerials mittels eines entsprechenden Schreibstrahles gezeigt. Grundsätzlich kann das erfindungsgemäße Verfahren jedoch für sämtliche Strukturierungsverfahren angewandt werden, bei welchen sequenziell Teilstrukturen in einem Schreibbereich geschrieben werden und eine Hauptrichtung für den Struktureintrag vorgegeben ist.

In der Figur 1 ist eine erste Art Strukturierungseinrichtung 10a dargestellt, bei welcher mittels einer Projektionseinrichtung 12 ein Schreibstrahlbündel 14 über eine entsprechende Apertur um eine Hauptrichtung 16 herum in die Hauptrichtung 16 abgestrahlt wird. Das Schreibstrahlbündel 14 weist z.B. eine räumliche Intensitätsvariation auf, welche zur Definition der gewünschten Struktur ausgebildet ist.

Die gewünschte Struktur ist in den Figuren 1 bis 4 insgesamt mit dem Bezugszeichen 18 bezeichnet (Gesamtstruktur). Die Strukturierungseinrichtung 10 weist konstruktionsbedingt einen räumlich begrenzten Schreibbereich 20 auf, innerhalb welchem eine Strukturierung erfolgen kann, beispielsweise mittels des Schreibstrahlbündels 14 (Figur 1).

In den dargestellten Beispielen wird das Schreibstrahlbündel beispielhaft in ein nicht näher dargestelltes Bad aus Lithografiematerial eingestrahlt, welches mittels des Schreibstrahlbündels 14 polymerisierbar und verfestigbar ist.

Da der Schreibbereich 20 eine geringere räumliche Ausdehnung als die gewünschte Gesamtstruktur 18 aufweist, wird die Gesamtstruktur in eine Mehrzahl von Teilstrukturen 22 zerlegt, welche in den Beispielen gemäß Figuren 1 und 2 blockartig ausgebildet sind und von einhüllenden Grenzflächen 24 berandet sind, welche sich im Falle der Figuren 1 und 2 parallel zu der Hauptrichtung 16 erstrecken.

Um die Gesamtstruktur 18 herzustellen, werden die Teilstrukturen 22 sequenziell nacheinander geschrieben, z.B. in einem in den Figuren angedeuteten Zerlegungsraster aus nebeneinander angeordneten Teilbereichen 22. Hierzu wird der Schreibbereich 20 sequenziell verlagert, beispielsweise indem ein nicht näher dargestelltes Substrat mittels einer Positionierungseinrichtung 26 relativ zu der Strukturierungseinrichtung 10 verschoben wird. Innerhalb des Schreibfeldes 20 kann eine Teilstruktur 22 beispielsweise jeweils wiederum sequenziell aus Schichten 28 aufgebaut werden, wie in den Figuren 1 bis 4 angedeutet. Hierzu kann beispielsweise das angesprochene Substrat schrittweise entlang der Hauptrichtung 16 verlagert werden.

Da in Beispiel der Figur 1 das Schreibstrahlbündel 14 aufgrund der Apertur einen nicht verschwindenden Bündelwinkel aufweist, können Abschnitte von bereits geschriebenen Teilstrukturen 22 zu einer Verschattung von Bereichen 30 in jeweils zu schreibenden Teilstrukturen 22 führen. Diese Verschattung in den Bereichen 30 führt zu Fehlstrukturierungen.

Die Figur 2 zeigt eine abweichende Methode zur Strukturierung, bei welcher ein Fokusbereich 32 des Schreibstrahlbündels mittels einer Strahlführungseinrichtung 34 (zum Beispiel Kippspiegel) kontrolliert in dem Schreibbereich 20 positioniert und verlagert werden kann. Hierzu ist eine zweite Art Strukturierungseinrichtung 10b vorgesehen. Dabei wird insbesondere ein scannendes Verfahren angewandt. Dabei kann jede der nacheinander geschriebenen Teilstrukturen 22 wiederum sequenziell aus Schichten 28 aufgebaut werden.

Auch bei dem in der Figur 2 skizzierten scannenden System erfolgt der Struktureintrag um die Hauptrichtung 16, da die Strahlführungseinrichtung 34 das Schreibstrahlbündel 14 um die Hauptrichtung 16 herum nur innerhalb des Schreibbereichs 20 steuern kann, sodass im zeitlichen und räumlichen Mittel der Energieeintrag entlang der Hauptrichtung 16 erfolgt

Auch hierbei tritt das Problem auf, dass einzelne Abschnitte der bereits vorhandenen Teilstrukturen 22 das Schreibstrahlbündel verschatten und somit bestimmte Bereiche 30 in dem Schreibfeld 20 für den Fokusbereich 32 nicht zugänglich sind.

Insgesamt können daher bei dem Vorgehen gemäß Figuren 1 und 2 die Teilstrukturen 22 nur eine sehr begrenzte Ausdehnung entlang der Hauptrichtung 16 aufweisen, da sonst die Bereiche 30 zu einer Unbrauchbarkeit der hergestellten Gesamtstruktur 18 führen würden.

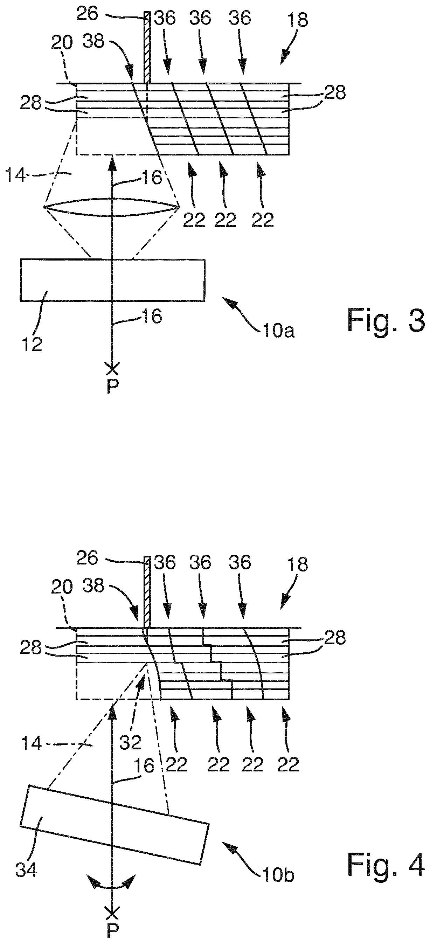

Anhand der Figuren 3 und 4 werden erfindungsgemäße Verfahren zur Herstellung der dreidimensionalen Struktur 18 erläutert, wobei Strukturierungseinrichtungen 10a (entsprechend Figur 1) und/oder 10b (entsprechend Figur 2) verwendet werden. Daher wird hinsichtlich der Merkmale der Strukturierungseinrichtungen 10a und 10b auf die Beschreibung zu den Figuren 1 und 2 Bezug genommen.

Zum Schreiben der Gesamtstruktur 18 werden wiederum sequenziell eine Mehrzahl von Teilstrukturen 22 mittels des Schreibstrahlbündels 14 definiert. Jede Teilstruktur 22 ist durch einhüllende Grenzflächen 36 begrenzt. Insbesondere ist die Gesamtstruktur 18 vollständig in Teilstrukturen 22 zerlegt, insbesondere derart, dass jeweils benachbarte Teilstrukturen 22 eine gemeinsame einhüllende Grenzfläche 36 aufweisen.

Die einhüllenden Grenzflächen verlaufen dabei im Gegensatz zu den Figuren 1 und 2 nicht parallel zu der Hauptrichtung 16 des Struktureintrags, sondern sind schräg zu der Hauptrichtung 16 orientiert.

Im Beispiel der Figur 3 verlaufen sämtliche einhüllenden Grenzflächen 36 im Wesentlichen parallel zueinander und weisen einen Winkel zu der Hauptrichtung 16, welcher gleich oder größer als der Bündelwinkel des Schreibstrahls 14 ist (wobei hierbei der zwischen Hauptrichtung 16 und Grenzfläche 36 eingeschlossene und sich in Richtung entgegen der Hauptrichtung 16 öffnende Winkel betrachtet wird).

Dies führt im Falle der Figur 3 dazu, dass bei dem sequenziellen Schreiben der Teilstrukturen 22 vermieden wird, dass Abschnitte von bereits vorhandenen Teilstrukturen 22 in dem Schreibbereich 20 zu Verschattungen der jeweils zu schreibenden Teilstruktur führen. Dies führt beispielsweise im Falle der Figur 3 dazu, dass die Teilstrukturen 22 eine im Vergleich zu Figur 1 deutlich größere Ausdehnung entlang der Hauptrichtung 16 aufweisen können.

Auch im Falle der Figur 4 unter Verwendung eines scannenden Systems (entsprechend Strukturierungseinrichtung 10b, vergleiche Figur 2) verlaufen die Grenzflächen 36, welche jeweils die sequenziell zu schreibenden Teilstrukturen 22 begrenzen, schräg zu der Hauptrichtung 16.

Grundsätzlich können die Grenzflächen 36 insbesondere auch komplexere Ausgestaltungen als einfache Ebenen aufweisen, beispielsweise abschnittsweise aneinander anschließende, unterschiedlich geneigte Ebenen und/oder abschnittsweise gekrümmt verlaufende Bereiche (vgl. Figur 4). Entscheidend ist auch hier, dass aufgrund des (lokal) geneigten Verlaufs der Grenzflächen 36 zu der Hauptrichtung 16 ein Verschatten durch bereits vorhandene Teilstrukturen 22 innerhalb des Schreibbereichs 20 vermieden wird.

Wie in den Figuren 3 und 4 ersichtlich, verlaufen die einhüllenden Grenzflächen 36 dabei jeweils derart, dass die Sichtlinie von jedem Abschnitt des Schreibbereichs 20 entgegen der Hauptrichtung 16 unverschattet ist. Insofern bilden die Grenzflächen 36 für die Teilstrukturen 22 jeweils Außenseiten 38 der bereits vorhandenen Teilstrukturen 22, welche vollständig einem entgegen der Hauptrichtung 16 beabstandeten Sichtpunkt P zugewandt sind und von diesem frei sichtbar sind.

## Patentansprüche

1. Verfahren zum Herstellen einer dreidimensionalen Gesamtstruktur (18) durch eine Energieeinstrahlmethode in einem durch Energieeintrag polymerisierbaren Lithografiematerial, mittels einer Strukturierungseinrichtung (10a, 10b), welche in einem Schreibbereich (20) eine vorgegebene Hauptrichtung (16) des Struktureintrags aufweist,
wobei die Gesamtstruktur (18) dadurch definiert wird, dass sequentiell eine Mehrzahl von sich insgesamt zu der Gesamtstruktur (18) ergänzenden Teilstrukturen (22) definiert werden, wobei die Teilstrukturen (22) jeweils innerhalb von einhüllenden Grenzflächen (36) begrenzt sind, wobei die Teilstrukturen (22) derart definiert werden, dass die einhüllenden Grenzflächen (36) schräg zu der Hauptrichtung (16) des Struktureintrags verlaufen,
wobei die Polymerisation des Lithografiematerials in wenigstens einem innerhalb des Schreibbereichs (20) räumlich verlagerbaren Fokusbereich (32) wenigstens eines Schreibstrahls (14) erfolgt,
**dadurch gekennzeichnet, dass** die Polymerisation des Lithografiematerials durch Zwei-Photonen-Absorption oder Multi-Photonen-Absorption in dem Fokusbereich (36) erfolgt,
und dass jeweils die Grenzfläche, welche eine jeweilige neu zu definierende Teilstruktur (22) in Richtung entgegengesetzt zu bereits vorhandenen Teilstrukturen (22) abgrenzt, derart verläuft, dass diese Grenzfläche (36) eine Außenseite (38) der bereits vorhandenen Teilstrukturen bildet und die Außenseite (38) von einem entgegengesetzt zur Hauptrichtung (16) beabstandeten Sichtpunkt (P) vollständig sichtbar ist.

2. Verfahren nach Anspruch 1, **dadurch gekennzeichnet, dass** die Teilstrukturen (22) durch Schnitte der Gesamtstruktur (18) mit den einhüllenden Grenzflächen (36) abgegrenzt sind.

3. Verfahren nach einem der vorhergehenden Ansprüche, **dadurch gekennzeichnet, dass** ein die Gesamtstruktur (18) repräsentierender Datensatz bereitgestellt wird, und dass hieraus weitere Datensätze rechnergestützt ermittelt werden, welche die Teilstrukturen (22) repräsentieren, wobei die Strukturierungseinrichtung (10a, 10b) gemäß den Datensätzen gesteuert wird.

4. Verfahren nach einem der vorhergehenden Ansprüche, **dadurch gekennzeichnet, dass** benachbarte Teilstrukturen (22) jeweils wenigstens eine identische einhüllende Grenzfläche (36) aufweisen.

5. Verfahren nach einem der vorhergehenden Ansprüche, **dadurch gekennzeichnet, dass** die einhüllenden Grenzflächen (36) mit der Hauptrichtung (16) des Struktureintrags einen spitzen Winkel einschließen, welcher entgegengesetzt zu der Hauptrichtung (16) geöffnet ist.

6. Verfahren nach einem der vorhergehenden Ansprüche, **dadurch gekennzeichnet, dass** die Teilstrukturen (22) in einem Zerlegungsraster angeordnet sind und jeweils wenigstens eine einhüllende Grenzfläche (36) einer Teilstruktur (22) parallel zu wenigstens einer einhüllenden Grenzfläche (36) einer weiteren Teilstruktur (22) verläuft.

7. Verfahren nach einem der vorhergehenden Ansprüche, **dadurch gekennzeichnet, dass** zum sequentiellen Definieren der Teilstrukturen (22) der Schreibbereich (20) der Strukturierungseinrichtung (10a, 10b) sequentiell verlagert wird und jeweils in dem Schreibfeld (20) eine Teilstruktur (22) geschrieben wird.

## Claims

1. A method for producing a three-dimensional overall structure (18) by an energy irradiation method in a lithography material that is polymerizable by energy input, using a structuring device (10a, 10b), which has within a writing region (20) a predefined principal direction (16) of the structure entry,
wherein the overall structure (18) is defined by sequentially defining a plurality of partial structures (22) that complement one another overall to form the overall structure (18), wherein the partial structures (22) are in each case delimited within enveloping interfaces (36), wherein the partial structures (22) are defined such that the enveloping interfaces (36) run obliquely with respect to the principal direction (16) of the structure entry,
wherein the lithography material is polymerized in at least one focus region (32) of at least one writing beam (14), said at least one focus region being spatially displaceable within the writing region (20),
**characterized in that** the lithography material is polymerized by two-photon absorption or multi-photon absorption in the at least one focus region (36),
and **in that** the interface (36) demarcating a respective partial structure (22) in a direction opposite to partial structures (22) already present in each case runs such that said interface (36) forms an outer side (38) of the partial structures already present and said outer side (38) is completely visible from a viewing point (P) spaced apart in a direction opposite to the principal direction (16).

2. The method as claimed in claim 1, **characterized in that** the partial structures (22) are demarcated by cuts of the overall structure (18) with the enveloping interfaces (36).

3. The method according to one of the preceding claims, **characterized in that** a data set representing the overall structure (18) is provided, and further data sets are determined therefrom in a computer-aided manner, said further data sets representing the partial structures (22), and wherein the structuring device (10a, 10b) is controlled in accordance with the data sets.

4. The method according to one of the preceding claims, **characterized in that** adjacent ones of the partial structures (22) in each case have at least one identical one of the enveloping interfaces (36).

5. The method according to one of the preceding claims, **characterized in that** the enveloping interfaces (36) form an acute angle with the principal direction (16) of the structure entry, said acute angle being open in a direction opposite to the principal direction (16).

6. The method according to any of the preceding claims, **characterized in that** the partial structures (22) are arranged in a decomposition grid and in each case at least one of the enveloping interfaces (36) of one of the partial structures (22) extends parallel to at least one of the enveloping interfaces (36) of a further one of the partial structures (22).

7. The method according to any of the preceding claims, **characterized in that** for sequentially defining the partial structures (22), the writing region (20) of the structuring device (10a, 10b) is sequentially displaced and in each case one of the partial structures (22) is written in the writing field (20).

## Revendications

1. Procédé de production d'une structure tridimensionnelle brute (18) grâce à un procédé d'irradiation d'énergie dans un matériau lithographique polymérisable par apport d'énergie, faisant appel à un dispositif de structuration (10a, 10b) qui, dans une région d'écriture (20), présente une direction principale (16) prédéfinie de la trame structurelle,
dans lequel la structure brute (18) est définie en ce qu'une pluralité de sous-structures (22) complémentaires de la structure brute (18) sont définies de manière séquentielle, dans lequel les sous-structures (22) sont respectivement délimitées à l'intérieur de surfaces limites enveloppantes (36), dans lequel les sous-structures (22) sont définies de telle manière que les surfaces limites enveloppantes (36) s'étendent obliquement par rapport à la direction principale (16) de la trame structurelle,
dans lequel la polymérisation du matériau lithographique a lieu dans au moins une région focale (32), pouvant être déplacée spatialement au sein de la région d'écriture (20), d'au moins un faisceau d'écriture (14),
**caractérisé en ce que** la polymérisation du matériau lithographique a lieu dans la région focale (32) par absorption à deux photons ou par absorption à plus de deux photons,
et **en ce que** la surface limite, qui délimite une sous-structure (22) à définir nouvellement respective dans la direction opposée à celle de sous-structures (22) déjà existantes, s'étend respectivement de telle manière que ladite surface limite (36) forme un côté extérieur (38) des sous-structures déjà existantes et le côté extérieur (38) est complètement visible depuis un point de vue (P) situé à distance dans une direction opposée à la direction principale (16).

2. Procédé selon la revendication 1, **caractérisé en ce que** les sous-structures (22) sont délimitées par des sections de la structure brute (18) comprenant les surfaces limites enveloppantes (36).

3. Procédé selon l'une quelconque des revendications précédentes, **caractérisé en ce qu'**un ensemble de données représentant la structure brute (18) est prévu, et **en ce que** d'autres ensembles de données qui représentent les sous-structures (22) sont déterminés par calcul à partir de celui-ci, dans lequel le dispositif de structuration (10a, 10b) est commandé conformément aux ensembles de données.

4. Procédé selon l'une quelconque des revendications précédentes, **caractérisé en ce que** des sous-structures (22) adjacentes présentent respectivement au moins une surface limite enveloppante (36) identique.

5. Procédé selon l'une quelconque des revendications précédentes, **caractérisé en ce que** les surfaces limites enveloppantes (36) font avec la direction principale (16) de la trame structurelle un angle aigu qui est ouvert dans une direction opposée à la direction principale (16) .

6. Procédé selon l'une quelconque des revendications précédentes, **caractérisé en ce que** les sous-structures (22) sont agencées selon une grille de dispersion et respectivement au moins une surface limite (36) d'une sous-structure (22) s'étend parallèlement à au moins une surface limite enveloppante (36) d'une autre sous-structure (22).

7. Procédé selon l'une quelconque des revendications précédentes, **caractérisé en ce que** la région d'écriture (20) du dispositif de structuration (10a, 10b) est déplacée de manière séquentielle en vue d'une définition séquentielle des sous-structures (22) et une sous-structure (22) est respectivement écrite dans le champ d'écriture (20).
